# EUROPEAN PATENT APPLICATION

(11) **EP 2 284 862 A1**
(43) Date of publication of application: **16.02.2011**
(21) Application number: 09167653.6
(22) Date of filing: 11.08.2009
(51) Int. Cl.: H01L 21/00, H05K 13/04

(54) **System and method for picking and placement of chip dies**

(71) Applicant: Nederlandse Organisatie voor Toegepast -Natuurwetenschappelijk Onderzoek TNO, 2628 VK Delft (NL)
(72) Inventor: van der Zon, Clemens Maria Bernardus, 5221 AW's-Hertogenbosch (NL)
(74) Representative: Hatzmann, Martin

(57) **Abstract**

According to an aspect of the invention, there is provided a chip die manipulator apparatus arranged for pick and placing of a chip die (30) in a chip manufacturing process, comprising: a pickup head arranged to pick up the chip die with an active side facing the first pickup head (11); a second pickup head (21) arranged to perform a flip chip movement of the chip die (30), to have the active side facing away from the second pickup head (21), wherein the first pickup head (11) comprises a test card (12) comprising contact pads arranged to contact the active side of the chip die (30); and a clamp for clamping the chip die against the contact pads.

Advantages may include reduction of the number of process steps and providing less breakdown risk in the manufacturing process due to in-place testing of chip dies.

## Description

### FIELD OF THE INVENTION

The invention relates to the field of picking and placing of a chip die in a chip manufacturing process.

### BACKGROUND OF THE INVENTION

As the need to assemble only good die (KGD Known Good Die) increases as result of cost-effective production, more and more test and inspection steps are introduced during the production and assembly of semiconductor chips. Currently electrical tests are carried out after the production of the wafer, before dicing the wafer into separate die (wafer probing) and after the final assembly of the chip prior to final packaging and shipment to the end-user chip testing).

In the event that electronic components are assembled through stacking of die on top of each-other (3D assembly) knowing that only correct functioning components are used becomes inevitable as it will be in new advanced semiconductor assembly. After wafer probing the die has met with different processes that may have damaged the die to make it un-suitable for further use. Therefore the need arises to verify the correct functioning of the component just before assembly. A general approach could be to add a test location to the machine where the single die can be probed conform the known wafer probing. The major drawback of such an approach is that, because testing has to be carried out in series with the assembly, additional cycle time is added to the overall cycle time. An increase of cycle time of up to 50% may be expected, thus reducing the production speed severely. Consequently the production costs will rise correspondingly.

A desire exists to reduce the number of process steps and to provide an enhanced testing method. US5796264 discusses probing arrangements and tests for (flip chip) dies.

### SUMMARY OF THE INVENTION

According to an aspect of the invention, there is provided a chip die manipulator apparatus arranged for picking and placing of a chip die in a chip manufacturing process, comprising: first and second pickup heads arranged to pick up a chip die with an active side facing the first pickup head; and pick the chip die from the first pickup head, to have the active side facing away from the second pickup head; and an aligner system for aligning the second pickup head relative to a substrate to place the chip die, wherein the first pickup head comprises a test card comprising contact pads arranged to contact the active side of the chip die; and a clamp for clamping the chip die against the contact pads.

According to another aspect, a method of picking and placing of a chip die in a chip manufacturing process is provided, comprising: providing first and second a pickup heads, the first pickup head comprising a test card with contact pads arranged to contact the chip die's active side; and a clamp for clamping the chip die against the contact pads; clamping the chip die's active side to the test card's contact pads to have the active side facing the first pickup head; and providing a chip die test by the test card; performing, consecutively, a flip chip movement of the chip die, to have the active side facing away from the second pickup head or have the chip die rejected; and aligning the second pickup head relative to a substrate to place the chip die.

Advantages may include reduction of the number of process steps and providing less breakdown risk in the manufacturing process due to in-place testing of chip dies.

### BRIEF DESCRIPTION OF THE DRAWINGS

Figure 1 shows a schematic of typical production steps for a chip-flip manufacturing process according to an aspect of the invention;
Figure 2 shows an example of a chip die manipulator apparatus arranged for picking and placing of a chip die in a chip manufacturing process; and
Figure 3 shows a further embodiment of the manipulator apparatus of Figure 2.

### DETAILED DESCRIPTION OF EMBODIMENTS

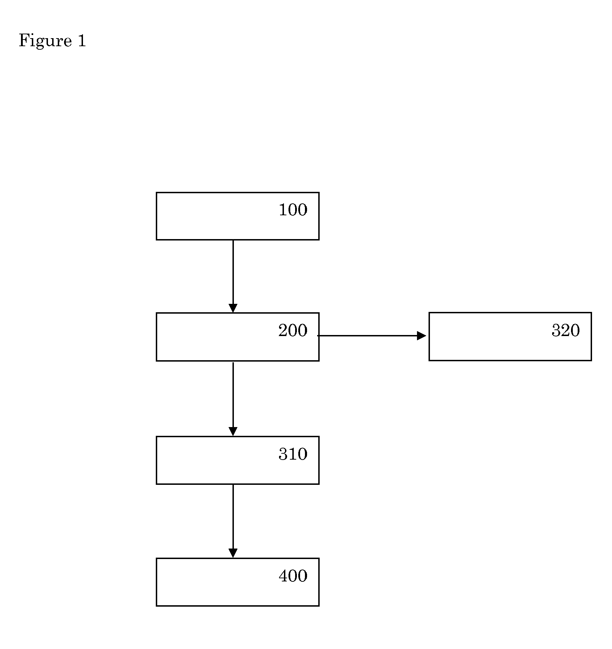

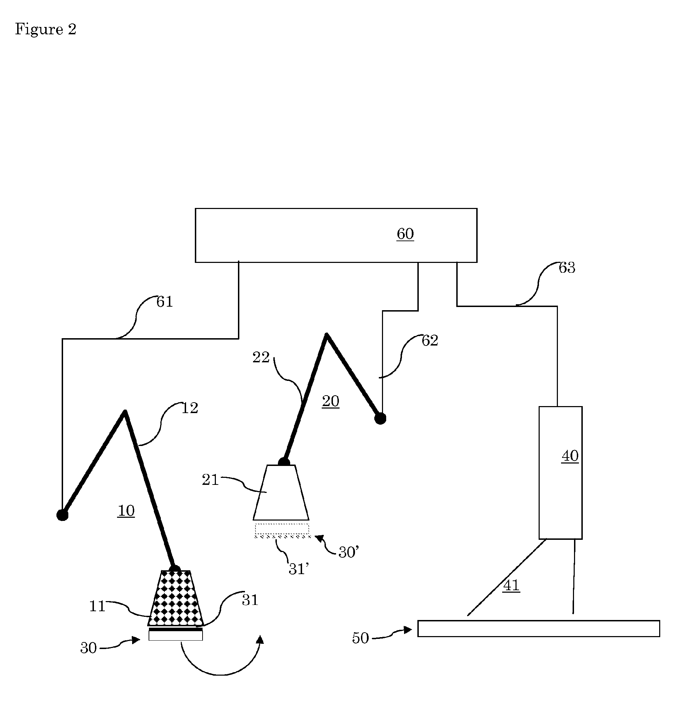

Now referring to Figure 1, there is provided a schematic of typical production steps 100-400 for a chip-flip manufacturing process according to an aspect of the invention. The method relies on providing first and second a pickup heads as further exemplified in Figure 2, the first pickup head comprising a test card with contact pads arranged to contact the chip die's active side; and a clamp for clamping the chip die against the contact pads. To further enhance the reliability of chip manufacturing, especially in the context of stacking dies in 3D electrically interconnected chip devices, wherein chip dies will be more and more fragile and reduced in thickness dimensions (typical dimension: 10-50 micron), the need for in place reliability testing will increase. That is, a die that was tested as known good die will have yet to be tested in a production step prior to manufacture, in order to secure its functioning and eliminate possible loss due to preceding manufacturing steps. It is noted that in the case of 3D stacked silicon devices, loss due to malfunction of a single device layer will be multiplied by the number of device layers, so that the need to prevent malfunction ever increases.

In a first step 100 a chip die's active side is clamped to a test card's contact pads to have the active side facing a first pickup head.

In a second step 200 an electrical chip die test is performed by the test card. Typical tests can be found in the art, for example in the cited US5796264, which is incorporated herein by reference. As an example a wafer probe includes various functional and parametric tests of each die. Test patterns, timing voltage margins, limits and test sequence are determined by individual product yields and reliability data. Four testing levels (C1, C2, C3, C7) have been established for semiconductor die. Standard probe (C1) level includes the standard test for gross functionality. Speed probe (C2) level tests the speed performance of a die for the fastest speed grades. Burned-in die (C3) level includes a burn-in test. Known good die (C7) level involves testing to provide a quality and reliability equal to package products. Any of these tests and/or variations or additions to these can be performed in principle.

In a third step 310, consecutively, a flip chip movement of the chip die is performed, to have the active side facing away from the second pickup head. In case of a negative test result, the chip die is rejected in alternative step 320 and the process sequence is aborted.

In case of positive test results, the second pickup head is aligned in a fourth step 400 relative to a substrate to place the chip die prior to placing the chip die on the substrate.

Figure 2 schematically shows an example of a chip die manipulator apparatus 10 according to an aspect of the invention, executing the steps discussed with reference to Figure 1. It is assumed that die 30 are presented with the contact side 31 up (as usual after dicing). The first step gathers the die from on diced wafer via manipulator 10.

To this, the manipulator apparatus comprises a pickup head 11 arranged to pick up the chip die 30 with an active side 31 facing the first pickup head 11 and a second pickup head 21 arranged to perform a flip chip movement of the chip die 30. It is noted that the flipping can be performed by either the first or second pickup head 11, 21. The result is shown in Figure 2 as greyed chip die 30', having the active side 31' facing away from the second pickup head 21. Thus the second manipulator 20 holds the die 30' with the active side 31' exposed, so the die 30 can be placed and bonded to the receiving body 50 (e.g. a substrate or other die).

First and second pickup heads 11 and 21 are actuated by manipulator arms 12 and 22 to form first and second manipulators 10 and 20. The manipulator apparatus is provided with a control system 60 controlling the actuating movement of manipulators 10 and 20 via signal lines 61 and 62 respectively, further, and alignment system 40 is provided to align the pickup head 21 via signal line 63, for proper placement of the chip die 30 to substrate 50. Placement can be done by optical inspection 41 or any other alignment method known in the art.

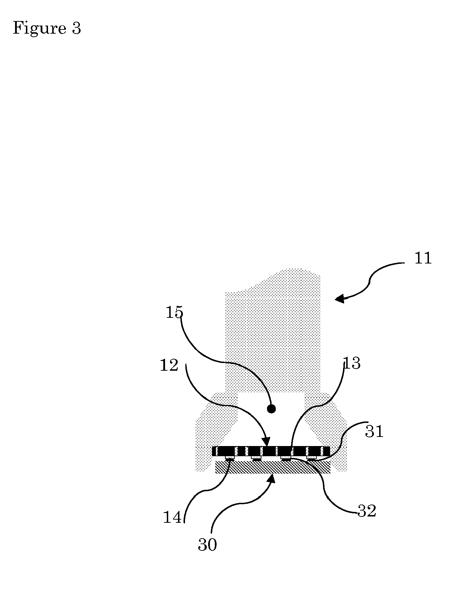

While any clamping method to clamp the die 30 to the pickup head 11 may be feasible, for example, spring clamping, electrostatic clamping or any other clamping method, preferably the clamping is performed by vacuum clamping as further exemplified in Figure 3.

According to an aspect of the invention, during the flip action, the die to be placed is held with the contact side 31 against pickup head 11 of manipulator 10, wherein a chip die test is performed. To this end, the first pickup head 11 comprises a test card (see further example Figure 3) comprising contact pads arranged to contact the active side of the chip die; and a clamp for clamping the chip die against the contact pads. In this approach the die can be tested for electrical performance during the total time the die resides within the flip-manipulator.

Figure 3 shows a further example of such a test card arrangement 12. In an embodiment, the test card 12 comprises vacuum via channels 13 arranged over substantially an entire contact surface to clamp the die over its entire surface for coupling with a vacuum pressure source (not shown), so as to provide a clamping force to the chip die 30 by vacuum clamping. The test card 12 can be mounted in a vacuum pressure orifice 15 of pickup head 11, preferably held by detachable couplings. This can be adjusted for specific die layouts of active surfaces 31, so that any bonding contacts 32 of chip die 30 are brought in contact with corresponding pads or bumps 14 of the test card. In this way test card 12 is kept relative to the vacuum pressure orifice 15 to couple the vacuum pressure via the vacuum via channels 13 to the chip die 30, which is accordingly held clamped against the test card 12. The test card may be made of suitable materials such as silicon, glass or epoxy based substrate material. The vacuum will hold the die under test and secure proper contact of the bumps 32 on the die 30 with the contacts 14 on the test card 12. Especially in view of the limited thickness of the die 30 and its consequent flexible characteristic, the vacuum pressure ensures good contact against the contact pads 14. Furthermore, an additional advantage of this invention is that the complete die 30 is supported during the flip-action including release from the carrier. In particular for thin die this is beneficial in comparison with present contact type pick-up nozzles that may damage the die 30 during pick-up from the carrier wafer.

During the time the flip action is ongoing, the electrical test can be carried out. Finally the die is released from the vacuum and transferred to the second manipulator fro placement. The invention can be applied during all movements in pick-and-place equipment, provided that the die to be tested is held at the contact side.

To avoid extensive wiring from the test structure to the outside world, the test card structure can be equipped with additional circuitry such as a multiplexer die, or such multiplexe function could be integrated directly in the test structure in case of a silicon test structure.

The invention may provide the following merits:
1. Electrical test can be performed in a pick-and-place environment without adding additional cycle time and therefore costs, due to production speed loss.
2. The use of a perforated test structure also supports manipulation of thin die.

In addition, this technique enables the potential for timely repairing a stack with a defective chip since testing can be done conveniently during flip chip bonding.

While the invention has been illustrated and described in detail in the drawings and foregoing description, such illustration and description are to be considered illustrative or exemplary and not restrictive; the invention is not limited to the disclosed embodiments. Furthermore, the skilled person will appreciate that the term test used herein is not limited to a specified physical designs, but may encompass all kinds of structures that may interconnect with chip die. Furthermore, the invention is not limited to specific types of tests but may include all kind of device and integrity tests, including electrical, optical and mechanical integrity.

Other variations to the disclosed embodiments can be understood and by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single unit may fulfill the functions of several items recited in the claims. The mere fact that certain measures are recited in mutually different dependent claims does not indicate that a combination of these measured cannot be used to advantage. Any reference signs in the claims should not be construed as limiting the scope.

## Claims

1. A chip die manipulator apparatus arranged for picking and placing of a chip die (30) in a chip manufacturing process, comprising:
- first and second pickup heads (11 and 21) arranged to pick up a chip die (30) with an active side facing the first pickup head (11); and pick the chip die (30) from the first pickup head (11), to have the active side facing away from the second pickup head (21); and
- an aligner system for aligning the second pickup head (21) relative to a substrate to place the chip die (30); wherein
- the first pickup head (11) comprises
o a test card comprising contact pads arranged to contact the active side of the chip die (30); and
o a clamp for clamping the chip die (30) against the contact pads.

2. A chip die manipulator apparatus according to claim 1, wherein the test card (12) comprises vacuum via channels (13) for coupling with a vacuum pressure source, so as to provide a clamping force to the chip die (30) by vacuum clamping.

3. A chip die manipulator according to claim 2, wherein the first pickup head (11) comprises a vacuum pressure orifice for detachable coupling with the test card (12), and the test card (12) is coupled to the orifice to couple the vacuum pressure via the vacuum via channels (13), so as to provide a test card (12) that can be selectively placed in the pickup head vacuum pressure orifice.

4. A method of picking and placing of a chip die (30) in a chip manufacturing process, comprising:
- providing first and second a pickup heads (11 and 21), the first pickup head (11) comprising a test card (12) with contact pads arranged to contact the chip die's active side; and a clamp for clamping the chip die (30) against the contact pads;
- clamping the chip die's (30) active side to the test card's (12) contact pads to have the active side facing the first pickup head (11); and
- performing an electrical chip die test by the test card (12);
- performing, consecutively, a flip chip movement of the chip die (30), to have the active side facing away from the second pickup head (21) or have the chip die (30) rejected; and
- aligning the second pickup head (21) relative to a substrate to place the chip die (30).
